(19) Europäisches Patentamt
European Patent Office
Office européen des brevets

(11) Veröffentlichungsnummer: **0 399 329 A2**

(12) **EUROPÄISCHE PATENTANMELDUNG**

(21) Anmeldenummer: **90109076.1**

(51) Int. Cl.5: **C08F 20/28, G03F 7/027**

(22) Anmeldetag: **14.05.90**

(30) Priorität: **20.05.89 DE 3916463**

(43) Veröffentlichungstag der Anmeldung:
**28.11.90 Patentblatt 90/48**

(84) Benannte Vertragsstaaten:
**DE FR GB IT**

(71) Anmelder: **HOECHST AKTIENGESELLSCHAFT**
**Postfach 80 03 20**
**D-6230 Frankfurt am Main 80(DE)**

(72) Erfinder: **Gersdorf, Joachim, Dr.**
**Lohmühlweg 17**
**D-6200 Wiesbaden(DE)**
Erfinder: **Kroggel, Matthias, Dr.**
**Am Flachsland 15**
**D-6233 Kelkheim(DE)**

(54) **Lichthärtbares elastomeres Gemisch und daraus erhaltenes Aufzeichnungsmaterial für die Herstellung von Reliefdruckplatten.**

(57) Es wird ein lichthärtbares elastomeres Gemisch beschrieben, das einen Photopolymerisationsinitiator, als Bindemittel ein in Wasser oder einer wäßrigen Lösung lösliches oder dispergierbares Pfropfpolymerisat, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen oder deren Verseifungsprodukten und ggf. von weiteren ethylenisch ungesättigten Monomeren oder deren Verseifungsprodukten aufgepfropft sind sowie mindestens eine radikalische polymerisierbare Verbindung der allgemeinen Formel

$$CH_2 = \underset{\substack{| \\ R_1}}{C} - \overset{\substack{O \\ //}}{C} - O - (X - O)_n - R_2$$

enthält.

Das Gemisch ist zur Herstellung von weichelastischen Reliefdruckplatten, insbesondere Flexodruckplatten, geeignet, zeigt eine Shore-A-Härte von 40 bis 70 und läßt sich mit Wasser oder wäßrigen Lösungen entwickeln.

EP 0 399 329 A2

# Lichthärtbares elastomeres Gemisch und daraus erhaltenes Aufzeichnungsmaterial für die Herstellung von Reliefdruckplatten

Die Erfindung betrifft ein lichthärtbares, negativ arbeitendes Gemisch und ein daraus erhaltenes Aufzeichnungsmaterial, das für die Herstellung von elastischen Reliefdruckplatten geeignet ist.

Gemische der genannten Gattung sind bekannt und enthalten gewöhnlich ein elastomeres Bindemittel, eine radikalisch polymerisierbare Verbindung und einen durch aktinische Strahlung aktivierbaren Polymerisationsinitiator. Derartige Gemische, die z. B. in der DE-C 22 15 090 beschrieben sind, lassen sich nach der Belichtung nur mit organischen Lösemitteln zum Reliefbild entwickeln.

In der US-A 4 042 386 und den DE-B 1 902 639 und 1 917 917 (zusammengefaßt in US-A 3 630 746) sowie DE-B 24 02 808 werden zwar wäßrig entwickelbare lichtempfindliche Aufzeichnungsmaterialien auf der Basis von teilverseiftem Polyvinylacetat zur Herstellung von Reliefdruckplatten beschrieben, jedoch wird zur Homogenisierung und Schichtausformung ein Zusatz von Wasser benötigt, der einen anschließenden Trocknungsprozeß notwendig macht. Weiterhin weisen diese Reliefdruckformen nicht die für den Flexodruck notwendige hohe Elastizität bzw. niedrige Shore-A-Härte auf.

In der DE-A 35 41 162 (= AU 86/65 535) und der EP-B 0 080 664 (= US-A 4 493 807) werden innerlich weichgemachte teilverseifte Polyvinylacetate als Bindemittel für lichtempfindliche Aufzeichnungsmaterialien beschrieben. Diese durch Polymerisation von Vinylestern in Gegenwart von Polyalkylenoxiden und anschließende Teilverseifung erhaltenen Pfropfpolymerisate sind zwar elastischer als reine teilverseifte Polyvinylacetate, bei der Verarbeitung der entsprechenden Photopolymergemische zu flächenförmigen Aufzeichnungsmaterialien ist aber ebenfalls Wasserzusatz notwendig.

In der älteren deutschen Patentanmeldung P 38 24 146.3 werden als Bindemittel für lichtempfindliche Aufzeichnungsmaterialien in Wasser oder in wäßrigen Lösungen lösliche oder dispergierbare Pfropfpolymerisate beschrieben, deren Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen oder deren Verseifungsprodukten und ggf. von weiteren ethylenisch ungesättigten Monomeren oder deren Verseifungsprodukten aufgepfropft sind. Die entsprechenden photopolymerisierbaren Gemische, basierend auf den dort beschriebenen Photomonomeren können zwar thermoplastisch zu flächenförmigen Aufzeichnungsmaterialien verarbeitet werden. Die Härte dieser Aufzeichnungsmaterialien ist aber für bestimmte Anwendungszwecke, z.B. im Flexodruck, zu hoch. Für den Flexodruck sollen insbesondere weichelastische Reliefdruckplatten mit Härten im Bereich von 40 bis 65 Shore-A eingesetzt werden.

Aufgabe der Erfindung war es daher, ein in Wasser oder wäßrigen Lösungen entwickelbares lichtempfindliches elastomeres Gemisch vorzuschlagen, das ohne Wasserzusatz durch thermoplastische Verarbeitung zu einer lichtempfindlichen Schicht verformt werden kann und aus dem sich eine weichelastische Reliefdruckplatte herstellen läßt.

Gegenstand der Erfindung ist ein lichthärtbares elastomeres Gemisch, das als wesentliche Bestandteile

a) als elastomeres Bindemittel ein in Wasser oder einer wäßrigen Lösung lösliches oder dispergierbares Pfropfpolymerisat, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen oder deren Verseifungsprodukten und ggf. von weiteren ethylenisch ungesättigten Monomeren oder deren Verseifungsprodukten aufgepfropft sind,

b) mindestens eine radikalisch polymerisierbare, mit dem Bindemittel verträgliche Verbindung mit mindestens einer endständigen ethylenisch ungesättigten Gruppe und einem Siedepunkt bei Normaldruck oberhalb 100 °C und

c) eine Verbindung oder eine Verbindungskombination enthält, die unter Einwirkung von aktinischem Licht die Polymerisation der Verbindung (b) einzuleiten vermag.

Das erfindungsgemäße Gemisch ist dadurch gekennzeichnet, daß mindestens eine der unter b) genannten radikalisch polymerisierbaren Verbindungen der allgemeinen Formel

$$CH_2 = \underset{\displaystyle R_1}{\underset{|}{C}} - \overset{\displaystyle O}{\overset{\|}{C}} - O - (X - O)_n - R_2$$

entspricht, worin
$R_1$ Wasserstoff oder Alkyl,
X Ethylen oder Propylen und
$R_2$ Alkyl
bedeuten, sowie
n eine Zahl von 1 bis 4 umfaßt.

Besonders bevorzugt ist
$R_1$ Wasserstoff oder ($C_1$-$C_3$) Alkyl, insbesondere Wasserstoff oder Methyl,
X Ethylen oder iso-Propylen und
$R_2$ ($C_1$-$C_3$) Alkyl, insbesondere Methyl oder Ethyl.

Bei den unter die allgemeine Formel fallenden erfindungsgemäß eingesetzten radikalisch polymerisierbaren Verbindungen handelt es sich um Mono- bzw. Oligoalkylenglykolmonoalkyletheracrylate bzw. -methacrylate, die überraschenderweise im Vergleich zu den hydroxylgruppenhal tigen Mono- bzw. Oligoalkylenglykolmonoacrylaten bzw. -methacrylaten weichere lichtvernetzte Schichten ergeben. Die Synthese dieser Verbindungen erfolgt in bekannter Weise durch Veresterung von Acryl- bzw. Methacrylsäure oder Umesterung der entsprechenden Methylester mit Mono-bzw. Oligoalkylenglykolalkylethern, z.B. Ethylenglykolmonomethylether, Diethylenglykolmonomethylethern, Diethylenglykolmonoethylether, Triethylenglykolmonomethylether und Propylenglykolmonomethylether.

Insbesondere überraschend ist, daß die erfindungsgemäß eingesetzten Oligoalkylenglykolmonoalkyletheracrylate bzw. -methacrylate auch im direkten Vergleich zu den entsprechenden Polyalkylenverbindungen erhebliche Vorteile aufweisen. Die aus den erfindungsgemäßen Gemischen hergestellten Photopolymerschichten zeigen z.B. im Vergleich zu Schichten, die die entsprechenden Polyalkylenverbindungen enthalten, keine Trübung.

Die erfindungsgemäß eingesetzten Monomere der allgemeinen Formel können auch in Mischung mit anderen Monomeren enthalten sein, die mehrere polymerisierbare olefinischen Doppelbindungen aufweisen, um eine gute Vernetzung herbeizuführen. Zu nennen sind insbesondere die Ester oder Amide von Acryl- und Methacrylsäure. Beispiele sind die Di- und Triacrylate und -methacrylate von mehrwertigen Alkoholen wie Ethylenglykol, Di- und Tri-, Tetra- oder Polyethylenglykolen, letztere bevorzugt mit 10 bis 15 Ethylenglykoleinheiten, 1,3-Propandiol, Glycerin, 1,1,1-Trimethylolpropan, 1,2,4-Butantriol oder Pentaerythrit, z.B. Ethylenglykoldimethacrylat, Triethylenglykoldiacrylat, Trimethylolpropantriacrylat und Trimethylolpropantrimethacrylat. Bevorzugt sind allerdings Gemische, die lediglich Monomere gemäß der allgemeinen Formel enthalten und darunter insbesondere diejenigen, die ein Monomeres enthalten. Sofern Mischungen von Monomeren im erfindungsgemäßen Gemisch vorliegen, so ist das Verhältnis derjenigen nach der allgemeinen Formel zu anderen genannten Monomeren 2:1 bis 25:1, insbesondere 5:1 bis 20:1. Im allgemeinen liegt die Menge an Monomeren bei etwa 5 - 70, bevorzugt bei etwa 10 - 50 Gew.-% der nichtflüchtigen Bestandteile des Gemisches.

Das erfindungsgemäße lichthärtbare elastomere Gemisch weist eine Shore-A-Härte von 40 bis 70, insbesondere von 45 bis 65 auf.

Das im erfindungsgemäßen Gemisch enthaltende Pfropfpolymerisat als Bindemittel ist in der älteren deutschen Patentanmeldung P 38 24 146.3 beschrieben.

Der Mengenanteil der im Bindemittel aufgepfropften Komponenten beträgt dabei im allgemeinen 10 bis 95, vorzugsweise 30 bis 90 und insbesondere 40 bis 80 Gew.-%, bezogen auf das gesamte Pfropfpolymerisat.

Die Pfropfgrundlagen bestehen aus Polyurethanen mit mindestens zwei Urethangruppen im Molekül, wobei die Anzahl der Urethangruppen pro Molekül nach oben keiner besonderen Begrenzung unterliegt und im allgemeinen höhere Werte als 2 hat.

Die als Pfropfgrundlage eingesetzten Polyurethane lassen sich nach üblichen Verfahren der Polyurethansynthese aus Diolen und Diisocyanaten herstellen und werden bevorzugt unter Verwendung von Katalysatoren, z. B. von tertiären Aminen oder organischen Zinnverbindungen, bei Temperaturen zwischen 60 und 120 °C, vorzugsweise zwischen 70 und 100 °C, synthetisiert.

Prinzipiell sind alle bei der Polyurethansynthese üblicherweise verwendeten Diole einsetzbar. Bevorzugt werden cycloaliphatische Diole, wie Cyclohexandiole, sowie aliphatische Diole mit vorzugsweise 2 bis 12 C-Atomen. Bevorzugt werden ferner Polyetherdiole, z. B. Polypropylenoxide, Polybutylenoxide, Mischpolymere aus Ethylenoxid, Propylenoxid, Butylenoxid, vorzugsweise deren Blockcopolymere; besonders bevorzugt werden Polyethylenoxide. Vorzugsweise werden Polyetherdiole, insbesondere Polyethylenglykole, mit Molekulargewichten zwischen 200 und 10 000 verwendet, wobei Polyethylenglykole mit Molekulargewichten zwischen 400 und 1500 besonders bevorzugt sind. Die Polyetherdiole werden gegebenenfalls in Kombination mit niedermolekularen aliphatischen Diolen, z. B. 1,4-Butandiol, 1,3-Propandiol, Ethylenglykol oder

Diethylenglykol, eingesetzt. Bevorzugt liegt ein molares Verhältnis von Polyetherdiol zu niedermolekularem aliphatischem Diol von 1 : 0,1 bis 1 : 0,7 vor.

Als Diisocyanatkomponenten können aromatische Diisocyanate, z. B. m- und p-Xylylendiisocyanat, Tolylen-2,4-diisocyanat, Tolylen-2,6-diisocyanat oder Gemische der beiden letzteren Isomeren, Naphthylen-1,5-diisocyanat, Diphenylmethan-4,4′-diisocyanat, Phenylbenzylether-4,4′-diisocyanat und dgl. eingesetzt werden.

Bevorzugt werden aliphatische und/oder cycloaliphatische Diisocyanate. Bevorzugte aliphatische Diisocyanate sind z. B. solche mit 2 bis 12 C-Atomen im aliphatischen Rest, z. B. Ethylendiisocyanat, Propylendiisocyanat, Tetramethylendiisocyanat, 2,2,4-Trimethylhexamethylendiisocyanat.

Bevorzugte cycloaliphatische Diisocyanate sind z. B. 1,4-Diisocyanato-cyclohexan, Dicyclohexylmethan-4,4′-diisocyanat und Isophorondiisocyanat. Besonders bevorzugt werden Hexamethylendiisocyanat und Isophorondiisocyanat.

Das Molverhältnis von Diol- zu Diisocyanatkomponente liegt vorzugsweise zwischen 1 : 0,99 und 1 : 0,5, insbesondere zwischen 1 : 0,98 und 1 : 0,7. Die mittleren Molekulargewichte der Polyurethane liegen vorzugsweise zwischen 200 und 100 000, insbesondere zwischen 1 300 und 50 000, besonders bevorzugt zwischen 3 000 und 25 000.

Zum Pfropfen auf das Polyurethan werden Carbonsäurevinylester mit 3 bis 20, vorzugsweise 4 bis 14 C-Atomen eingesetzt. Besonders bevorzugt werden Vinylacetat und/oder Vinylpropionat, insbesondere Vinylacetat. Bevorzugt werden ferner Gemische aus Vinylacetat und/oder Vinylpropionat und Vinylversatat. Insbesondere bei Teil- oder Vollverseifung der Produkte im Anschluß an die Pfropfpolymerisation ist beim Pfropfen die Mitverwendung von Vinylpropionat neben Vinylacetat vorteilhaft. Außerdem lassen sich copolymerisierbare Gemische aus Vinylcarbonsäureestern pfropfen, vorzugsweise Gemische aus Vinylacetat und Vinylversatat, wobei der Vinylversatatanteil 0,2 bis 10 Gew.-%, vorzugsweise 0,5 bis 5 Gew.-%, bezogen auf den Vinylacetatanteil, beträgt. Auch das Pfropfen mit verschiedenen Carbonsäurevinylestern in Form von Blockcopolymeren, gegebenenfalls in Kombination mit weiteren ethylenisch ungesättigten und copolymerisationsfähigen Monomeren, kann vorteilhaft sein. Weiterhin können die Carbonsäurevinylester auch zusammen mit anderen ethylenisch ungesättigten und copolymerisierbaren Monomeren, wie Maleinsäure, Itaconsäure, Mesaconsäure, Crotonsäure, Acrylsäure oder deren Estern, gepfropft werden.

Die erhaltenen Pfropfpolymerisate lassen sich durch Hydrolyse, Alkoholyse oder Umesterung in teil- oder vollverseifte Produkte überführen, wobei der Hydrolysegrad mindestens 1 mol-%, vorzugsweise 70 bis 99 mol-%, bezogen auf die Molzahl verseifbarer Monomereinheiten im Pfropfpolymerisat, beträgt. Die Herstellung der Pfropfpolymerisate mit Polyurethan-Pfropfgrundlage ist in der deutschen Patentanmeldung P 37 32 089 beschrieben.

Das erfindungsgemäße lichtempfindliche Gemisch enthält im allgemeinen 20 - 95, vorzugsweise 30 - 70 Gew.-% dieses Bindemittels.

Als Photoinitiatoren für das erfindungsgemäße Gemisch kommt alle bekannten Verbindungen in Frage, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivate, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der älteren deutschen Patentanmeldung P 38 27 735.2 beschriebenen 6-Acyl-(6H)-dibenz-[c,e][1,2]-oxaphosphorin-6-oxide, insbesondere das 6-(2,4,6-Trimethylbenzoyl)-(6H)-dibenz-[c,e][1,2]-oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10, bevorzugt etwa 0,5 bis 5 Gew.-% des genannten lichtempfindlichen Gemisches.

Oft ist es von Vorteil, dem lichtempfindlichen Gemisch noch weitere Hilfs- und Zusatzstoffe zuzugeben, z. B. Inhibitoren der thermischen Polymerisation wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Das erfindungsgemäße Gemisch läßt sich für die Herstellung von Relief- und Flexodruckplatten durch Gießen aus Lösung oder Extrudieren und Kalandrieren zu Schichten einer Dicke von 0,02 bis 6, vorzugsweise von 0,2 bis 2 mm, ausformen. Die Schicht kann auf die Oberfläche eines geeigneten Trägers laminiert oder eine Lösung des erfindungsgemäßen Gemisches kann zur Ausbildung eines Aufzeichnungsmaterials auf einen Schichtträger aufgebracht werden.

Das in dieser Weise hergestellte erfindungsgemäße Aufzeichnungsmaterial kann als Reliefdruckplatte, insbesondere als Flachdruckplatte, Tiefdruckzylinder, Siebdruckschablone oder als Photoresist verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol, oder eine abziehbare Deckfolie, z. B. aus Polyethylenterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Das erfindungsgemäße Aufzeichnungsmaterial kann bildmäßig mit aktinischem Licht aus Lichtquellen wie Quecksilberdampflampen oder Leuchtstofföhren belichtet werden, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit Wasser oder wäßrigen Lösungen, z. B. von Netz- oder Emulgiermitteln, erfolgen. Der Lösung können ferner kleine Mengen Entschäumer oder mit Wasser mischbare organische Lösemittel, z. B. niedere aliphatische Alkohole, zugesetzt werden. Der Mengenanteil an organischen Lösemitteln ist im allgemeinen kleiner als 10 %, bevorzugt kleiner als 5%. Zweckmäßig werden die entwickelten Reliefformen bei Temperaturen bis 120 °C getrocknet und gegebenenfalls gleichzeitig oder danach mit aktinischem Licht nachbelichtet.

Das erfindungsgemäße Aufzeichnungsmaterial eignet sich insbesondere zur Herstellung von Druckformen, vor allem Hoch- oder Reliefdruckformen, die besonders für den Flexodruck geeignet sind.

Die Erfindung wird durch die nachstehenden Beispiele erläutert. Die Grenzviskositätszahlen $J_o$ in ml/g wurden bei 25 °C im Ostwaldviskosimeter ermittelt. Die Hydrolysegrade (in mol-%) beziehen sich auf die hydrolysierbaren Monomereinheiten im unverseiften Pfropfpolymerisat. Die Bestimmung der Härte in Einheiten von Shore-A ist nach der DIN Norm 53 505 durchgeführt worden.

## Herstellung des Pfropfpolymerisats

### Synthese der Polyurethan-Pfropfgrundlage:

3.000 g Polyethylenglykol 600 und 193,1 g 1,4-Butandiol werden gemeinsam mit 1,5 ml 1,4-Dimethylpiperazin auf 75° C erwärmt und innerhalb von sechs Stunden mit 1.428,2 g Isophorondiisocyanat versetzt. Anschließend läßt man zwei Stunden bei 80° C nachreagieren. $J_o$ des so hergestellten Polyurethans beträgt in Methanol 10,6.

### Synthese des Pfropfpolymerisats

2.370 g der Polyurethan-Pfropfgrundlage werden auf 80° C erwärmt und unter Rühren mit einem Gemisch von 3.555 g Vinylacetat und 26,7 g Dibenzoylperoxid (75%ig) innerhalb von fünf Stunden versetzt. Nach einer Reaktionszeit von 45 Minuten bei 80° C wird nicht umgesetztes Vinylacetat durch azeotrope Destillation mit Methanol entfernt. $J_o$ des so hergestellten Pfropfpolymerisats beträgt in THF 16,8.

### Verseifung des Pfropfpolymerisats:

10.258 g einer 50%igen methanolischen Lösung des Pfropfpolymerisats wird bei Raumtemperatur mit 198 g 10%iger methanolischer NaOH und 198 g Wasser versetzt. Die Mischung geliert nach einiger Zeit und wird granuliert. Nach zwei Stunden schlämmt man das erhaltene Granulat in Methanol auf und setzt eine zur NaOH äquivalente Menge an Essigsäure zu. Das Produkt wird abfiltriert, mehrmals mit Methanol gewaschen und getrocknet: $J_o$ beträgt in Wasser 10,0, der Hydrolysegrad 90,6 %.

Anwendungsbeispiel 1

57,4 Gt des in dem Herstellungsbeispiel beschriebenen verseiften Pfropfpolymerisats, 37,8 Gt Diethylenglykolmonoethylethermonoacrylat, 2 Gt Trimethylolpropantriacrylat, 2 Gt Benzildimethylketal und 0,8 Gt 2,6-Di-tert.butyl-4-methylphenol werden bei 160° C in einem Zweischneckenextruder zu einer transparenten Schmelze homogenisiert und anschließend in einer Plattenpresse zwischen einer 0,125 mm dicken Polyesterfolie und einem 0,3 mm dicken anodisch oxydierten Aluminiumblech, das mit einer Polyurethanhaftschicht versehen ist, bei 155° C zwei Mi nuten zu einer 0,8 mm dicken Schicht heißgepreßt. Nach Abziehen der Polyesterfolie wird drei Minuten bildmäßig mit einem UVA-Flachbelichter belichtet und drei Minuten mit Wasser von 40° C entwickelt. Nach dem Trocknen erhält man eine Reliefdruckplatte mit einer Shore-A-Härte von 58.

Anwendungsbeispiel 2

57,4 Gt des in dem Herstellungsbeispiel beschriebenen verseiften Pfropfpolymerisats, 37,8 Gt Diethylenglykolmonomethylethermonoacrylat, 2 Gt Trimethylolpropantriacrylat, 2 Gt Benzildimethylketal und 0,8 Gt 2,6-Di-tert.butyl-4-methylphenol werden analog zum Anwendungsbeispiel 1 homogenisiert und zu einer Reliefdruckplatte verarbeitet. Die Härte der vernetzten Photopolymerschicht beträgt 47 Shore-A.

Anwendungsbeispiel 3

57,4 Gt des in dem Herstellungsbeispiel beschriebenen verseiften Pfropfpolymerisats, 37,8 Gt Diethylenglykolmonomethylethermonomethacrylat, 2 Gt Trimethylolpropantriacrylat, 2 Gt Benzildimethylketal und 0,8 Gt 2,6-Di-tert.butyl-4-methylphenol werden analog zum Anwendungsbeispiel 1 homogenisiert und zu einer Reliefdruckplatte verarbeitet. Die Härte der vernetzten Photopolymerschicht beträgt 58 Shore-A.

Anwendungsbeispiel 4

57,4 Gt des oben beschriebenen verseiften Pfropfpolymerisats, 37,8 Gt Triethylenglykolmonomethylethermonoacrylat, 2 Gt Trimethylolpropantriacrylat, 2 Gt Benzildimethylketal und 0,8 Gt 2,6-Di-tert.butyl-4-methylphenol werden analog zum Anwendungsbeispiel 1 homogenisiert und zu einer Reliefdruckplatte verarbeitet. Die Härte der vernetzten Photopolymerschicht beträgt 52 Shore-A.

Anwendungsbeispiel 5

57,4 Gt des oben beschriebenen verseiften Pfropfpolymerisats, 37,8 Gt 1,2-Propandiol-monomethylethermonoacrylat, 2 Gt Trimethylolpropantriacrylat, 2 Gt Benzildimethylketal und 0,8 Gt 2,6-Di-tert.butyl-4-methylphenol werden analog zum Anwendungsbeispiel 1 homogenisiert und zu einer Reliefdruckplatte verarbeitet. Die Härte der vernetzten Photopolymerschicht beträgt 55 Shore-A.

Vergleichsbeispiel 1

57,4 Gt des in dem Herstellungsbeispiel beschriebenen verseiften Pfropfpolymerisats, 37,8 Gt Diethylenglykolmonoacrylat, 2 Gt Trimethylolpropantriacrylat, 2 Gt Benzildimethylketal und 0,8 Gt 2,6-Di-tert.butyl-4-methylphenol werden analog zum Anwendungsbeispiel 1 homogenisiert und zu einer Reliefdruckplatte verarbeitet. Die Härte der vernetzten Photopolymerschicht beträgt 71 Shore-A.

Vergleichsbeispiel 2

57,4 Gt des in dem Herstellungsbeispiel beschriebenen verseiften Pfropfpolymerisats, 37,8 Gt Polyethylenglykolmonomethylethermonomethacrylat (Bisomer MPEG (350) MA der Fa. BP Chemicals Ltd. mit durchschnittlich acht $CH_2CH_2O$-Einheiten), 2 Gt Trimethylolpropantriacrylat, 2 Gt Benzildimethylketal und

0,8 Gt 2,6-Di-tert.butyl-4-methylphenol werden analog zum Anwendungsbeispiel 1 homogenisiert und zu einer Reliefdruckplatte verarbeitet. Die unbelichtete Photopolymerschicht zeigt eine deutliche Trübung. Die Reliefausbildung der fertig entwickelten Druckplatte ist daher wesentlich schlechter als beim Anwendungsbeispiel 3.

## Ansprüche

1. Lichthärtbares elastomeres Gemisch, das als wesentliche Bestandteile

a) als elastomeres Bindemittel ein in Wasser oder einer wäßrigen Lösung lösliches oder dispergierbares Pfropfpolymerisat, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen oder deren Verseifungsprodukten und ggf. von weiteren ethylenisch ungesättigten Monomeren oder deren Verseifungsprodukten aufgepfropft sind,

b)mindestens eine radikalisch polymerisierbare, mit dem Bindemittel verträgliche Verbindung mit mindestens einer endständigen ethylenisch ungesättigten Gruppe und einem Siedepunkt bei Normaldruck oberhalb 100° C und

c) eine Verbindung oder eine Verbindungskombination enthält, die unter Einwirkung von aktinischem Licht die Polymerisation der Verbindung (b) einzuleiten vermag,

dadurch gekennzeichnet, daß mindestens eine der unter b) genannten radikalisch polymerisierbaren Verbindungen der allgemeinen Formel

$$CH_2 = \underset{\displaystyle R_1}{\underset{|}{C}} - \overset{\displaystyle O}{\overset{\|}{C}} - O - (X - O)_n - R_2$$

entspricht, worin

$R_1$ Wasserstoff oder Alkyl,

X Ethylen oder Propylen,

$R_2$ Alkyl

bedeuten, sowie

n eine Zahl von 1 bis 4 umfaßt.

2. Lichthärtbares Gemisch nach Anspruch 1, dadurch gekennzeichnet, daß

$R_1$ Wasserstoff oder $(C_1\text{-}C_3)$Alkyl und

$R_2$ $(C_1\text{-}C_3)$Alkyl bedeuten.

3. Lichthärtbares Gemisch nach Anspruch 1, dadurch gekennzeichnet, daß

$R_1$ Wasserstoff oder Methyl,

X Ethylen oder iso-Propylen und

$R_2$ Methyl oder Ethyl bedeuten.

4. Lichthärtbares Gemisch nach einem oder mehreren der Ansprüche 1 bis 3, dadurch gekennzeichnet, daß das Gemisch eine Shore-A-Härte von 40 bis 70, insbesondere von 45 bis 65 aufweist.

5. Lichthärtbares Gemisch nach Anspruch 1, dadurch gekennzeichnet, daß das Pfropfpolymerisat 10 bis 95 Gew.-% aufgepfropfte Bestandteile enthält.

6. Lichthärtbares Gemisch nach Anspruch 1, dadurch gekennzeichnet, daß das Diisocyanat ein aliphatisches oder cycloaliphatisches Diisocyanat ist.

7. Lichthärtbares Gemisch nach Anspruch 1, dadurch gekennzeichnet, daß das Diol ein Gemisch aus einem Polyetherdiol und einem monomeren Diol ist.

8. Lichthärtbares Gemisch nach Anspruch 7, dadurch gekennzeichnet, daß 0,1 bis 0,7 mol monomeres Diol je mol Polyetherdiol eingesetzt werden.

9. Lichthärtbares Gemisch nach Anspruch 1, dadurch gekennzeichnet, daß das Molverhältnis von Diol- zu Diisocyanatkomponente 1 : 0,99 bis 1 : 0,5 beträgt.

10. Lichthärtbares Gemisch nach Anspruch 1, dadurch gekennzeichnet, daß Einheiten von Vinylestern mit 4 bis 12 Kohlenstoffatomen aufgepfropft werden.

11. Lichthärtbares Gemisch nach Anspruch 1, dadurch gekennzeichnet, daß das Pfropfpolymerisat zu 70 bis 99 mol-%, bezogen auf die Zahl verseifbarer Monomereinheiten, verseift ist.

12. Lichthärtbares Gemisch nach Anspruch 1, dadurch gekennzeichnet, daß es 20 bis 95 Gew.-% Pfropfpolymerisat, 5 bis 70 Gew.-% polymerisierbare Verbindungen und 0,01 bis 10 Gew.-% Photopolymerisationsinitiator enthält.

13. Lichthärtbares Aufzeichnungsmaterial mit einem Schichtträger und einer lichthärtbaren Schicht, dadurch gekennzeichnet, daß die lichthärtbare Schicht aus einem Gemisch gemäß einem der Ansprüche 1 bis 12 besteht.